# EUROPEAN PATENT APPLICATION

(11) **EP 3 816 564 A1**
(43) Date of publication of application: **05.05.2021**
(21) Application number: 19275110.5
(22) Date of filing: 29.10.2019
(51) Int. Cl.: F28D 15/04, H01L 23/427, H05K 7/20

(54) **COOLING DEVICE FOR COOLING ELECTRONIC COMPONENTS**

(71) Applicant: BAE SYSTEMS plc, London SW1Y 5AD (GB)
(72) Inventor: The designation of the inventor has not yet been filed
(74) Representative: BAE SYSTEMS plc Group IP Department

(57) **Abstract**

A cooling device (1) for transferring heat away from components of an electronic device. The cooling device comprises a pressure vessel (3). The pressure vessel (3) comprises an evaporator (11). The evaporator (11) is arranged to be sufficiently close to a component to enable thermal transfer from a component to the evaporator (11). The cooling device (1) comprises a condenser end (15), and a working fluid (7) provided within the pressure vessel (3). The working fluid (7) absorbs heat at the evaporator (11), thereby generating a pressure gradient within the pressure vessel (3). The pressure gradient causes the working fluid (7) to away flow from the evaporator end (11) towards the condenser end (15), thereby transferring heat away from the component.

## Description

### Field

The present invention concerns a cooling device for transferring heat away from components of an electronic device. In particular, the invention concerns a cooling device comprising a pressure vessel and a working fluid, wherein the working fluid flows under a pressure gradient to transfer heat away from a component.

### Background

Electronic devices generate significant heat, which can lead to reduced performance, and can be dangerous, leading to increased risks of sparks or fires, or failure of components of the devices. In equipment enclosures, where multiple electronic components may be housed together, or in close proximity, problems associated with heat generation from the components may be more severe. This effect is further amplified in cases where equipment enclosure needs to be sealed, for example, in order to provide security protection.

Cooling mechanisms are often required to limit the problems associated with heat generated by the components. Known cooling mechanisms are water cooling mechanisms, which may rely on pumping water via channels adjacent to the components, or air cooling mechanisms, which may include fans to increase the rate of heat transfer away from the components. Water cooling mechanisms and air cooling known mechanisms will typically require pumps or fans to maintain flow of the coolant (air or water), thus enabling the rate of heat transfer away from the components to be maintained. There remains a need for more efficient and reliable methods of cooling electronic devices.

### Summary

According to a first aspect, the invention provides a cooling device according to claim 1.

According to a second aspect, the invention comprises a method according to claim 15.

According to a third aspect, the invention provides an equipment enclosure according to claim 15.

It will of course be appreciated that features described in relation to one aspect of the present invention may be incorporated into other aspects of the present invention. For example, the method of the invention may incorporate any of the features described in relation to the apparatus of the invention, and vice versa.

### Description of the Drawings

Embodiments of the present invention will now be described by way of example only with reference to the accompanying schematic drawings of which:
Figure 1 is a schematic view of a cooling device according to an embodiment of the invention.
Figure 2 is a schematic view of an equipment enclosure comprising a cooling device, according to an embodiment of the invention.

### Detailed Description

According to a first aspect, the invention provides a cooling device for transferring heat away from components of an electronic device. The cooling device comprises a pressure vessel, wherein the pressure vessel comprises an evaporator, and wherein the evaporator arranged to be sufficiently close to a component to enable thermal transfer from a component to the evaporator. The cooling device comprises a condenser end, and a working fluid provided within the pressure vessel. The working fluid absorbs heat at the evaporator and vaporises, thereby generating a pressure gradient within the pressure vessel. The pressure gradient causes the working fluid to away flow from the evaporator end towards the condenser end, thereby transferring heat away from the component. The evaporator may be in thermal contact with the component, or may be proximate to the component. The evaporator may be adjacent to, or in contact with the component. The evaporator may act as a heat sink of the heat generated from the component.

The cooling device may comprise a wick structure, wherein the wick structure is arranged on the inside of the pressure vessel. The wick structure may be arranged to be sufficient close to a heat-generating component to enable thermal transfer from the component to the wick structure. The wick structure may be in thermal contact with the component, or may be proximate to the component. The wick structure may be adjacent to, or in contact with the component. The wick structure may act as a heat sink of the heat generated from the component. The evaporator and/or the wick structure may be arranged at an end of the cooling device. The evaporator and/or the wick structure may be arranged at the opposite end of the cooling device to the condenser.

The wick structure may comprise a porous wick structure. The wick structure may comprise sintered copper powder. The wick structure may enable more efficient transfer from a component to the working fluid. A porous wick structure may have an increased surface area, thus further improving the efficiency of heat transfer.

The wick structure may comprise sintered copper powder.

The wick structure may comprise a plurality of groves that provide channels running along the longitudinal direction of the pressure vessel. The wick structure may assist in transferring fluid away from the condenser along the longitudinal direction of the pressure vessel.

The working fluid may condense at the condenser end. The temperature of the condensing end may be between -5°C and 40°C degrees °C. The temperature of the evaporator will be at least in part determined by heat generated by components proximate to the evaporator.

The condenser end may be sufficiently close to a heat exchanger to enable thermal transfer from the component to the heat exchanger. The condenser end may be in thermal contact with the heat exchanger, or may be proximate to the heat exchanger. The condenser end may be adjacent to, or in contact with the heat exchanger.

Working fluid may be return to the evaporator from the condenser end and reused. Fluid that has condensed at the condenser end may be returned to the evaporator and may be reused to absorb further heat from the same component or from additional components.

The working fluid may return to the evaporator from the condenser end under gravity.

The working fluid may return to the evaporator from the condenser end via capillary forces developed in the wick structure.

The pressure vessel may comprise a material having high strength and/or high thermal conductivity. The pressure vessel may comprise a material with a tensile strength greater than 70 GPa, or greater than 130 GPa. The pressure vessel may comprise a material with a thermal conductivity greater than 200 W/m·K or greater than 400 W/m·K. The pressure vessel may comprise copper or aluminium.

The working fluid may comprise a fluid having a high latent heat of vaporisation and/or a high thermal conductivity. The working fluid may comprise a fluid having a latent head of vaporisation greater than 800 kJ/kg or greater than 1000 kJ/kg. The working fluid may comprise a fluid having a thermal conductivity greater than 0.15 Wm-1K-1 or greater than 0.5 Wm-1K-1 at room temperature. The working fluid may comprise liquid helium, ammonia, or alcohol such as ethanol.

The condenser end of the device may be bifurcated such that the condenser end comprises at least two branches. A heat exchanger is arranged to be sufficiently close to each branch of the condenser end to enable thermal transfer from the condenser end to the heat exchanger. Each condenser end branch may be in thermal contact with a heat exchanger, or may be proximate to a heat exchanger. Each condenser end branch may be adjacent to, or in contact with a heat exchanger.

This may enable more efficient transfer of heat away from the cooling device, and therefore more efficient cooling of components. More than one branch of the condenser end may be associated with a single heat exchanger. Branches of the condenser end may be disposed adjacent to more than one heat exchanger. In embodiments one branch of the condenser end is disposed adjacent a first heat exchanger and another branch of the condenser end is disposed adjacent a second heat exchanger. In embodiments, when the heat pipe is not bifurcated, a heat exchanger may be disposed on either side of the condenser end of the cooling device.

The evaporator may be bifurcated such that the evaporator comprises at least two branches. Each branch may be arranged to be sufficiently close to a heat-generating component to enable thermal transfer from the component to the evaporator branch. Each evaporator branch may be in thermal contact with a component, or may be proximate to a component. Each evaporator branch may be adjacent to, or in contact with a component. This may enable a single cooling device to cool a plurality of spatially separated heat-generating components, or to absorb heat from a component in a plurality of different directions.

According to a second aspect, the invention provides a method of cooling components of an electronic device using a cooling device. The method comprises providing a pressure vessel, the pressure vessel having an evaporator and a condenser end. The method comprises configuring the pressure vessel such that the evaporator is sufficiently close to a component to enable thermal transfer from the component to the evaporator. The method comprises providing a working fluid within the pressure vessel. The working fluid absorbs heat from the component at the evaporator, thereby generating a pressure gradient within the pressure vessel. The pressure gradient causes the working fluid to away flow from the evaporator towards the condenser end, thereby transferring heat away from the component. The cooling device may comprise any of the features of the cooling device that are set out above.

According to a third aspect, the invention provides an equipment enclosure for housing components of an electronic device, the equipment enclosure comprising a cooling device. The cooling device comprises a pressure vessel comprising an evaporator, wherein the evaporator is arranged to be sufficiently close to a component to enable thermal transfer from the component to the evaporator. The thermal device comprises a condenser end, and a working fluid provided within the pressure vessel. The working fluid absorbs heat at the evaporator and vaporises, thereby generating a pressure gradient within the pressure vessel. The pressure gradient causes the working fluid to away flow from the evaporator end towards the condenser end, thereby transferring heat away from the component. The cooling device may incorporate any of the features set out above.

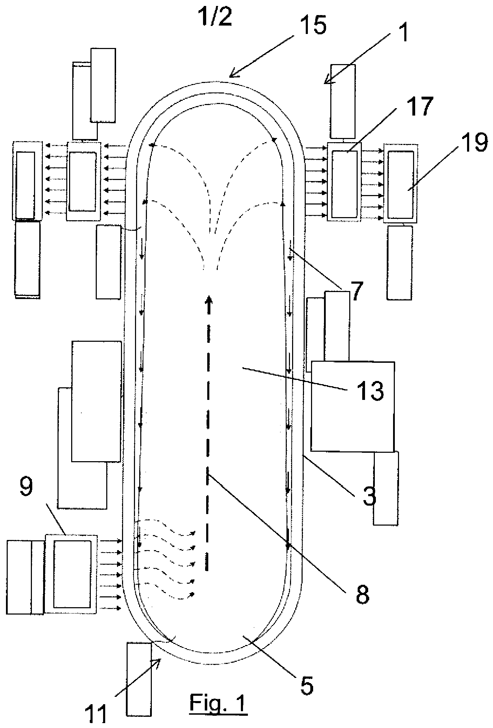

Figure 1 is a schematic view of an example cooling device 1 according to an embodiment of the invention, The cooling device comprises a pressure vessel 3, a porous wick structure 5 and a working fluid 7. The wick structure 5 is arranged on the inside of the vessel 3 proximate to a heat-generating component of the device 9. The wick structure 5 is arranged at an end of the heat pipe 1 and this end of the heat pipe 1 functions as an evaporator 11. Heat from the heat-generating component 9 is input at the evaporator 11. This causes the working fluid 7 to vaporise, creating a pressure gradient. The pressure gradient pushes the vapour 8 to flow along the cooling device 1, through a central channel 13 to a condenser end 15. The condenser end 15 is proximate to a heat exchanger 17. At the condenser end 15 the vapour 8 condenses due to this end being cooler, giving up its latent heat of vaporisation. Heat is transferred to the atmosphere 19 via the heat exchanger 17. The working fluid 7 is then returned to the evaporator end 11 by capillary forces developed in the wick structure 5 or by gravity.

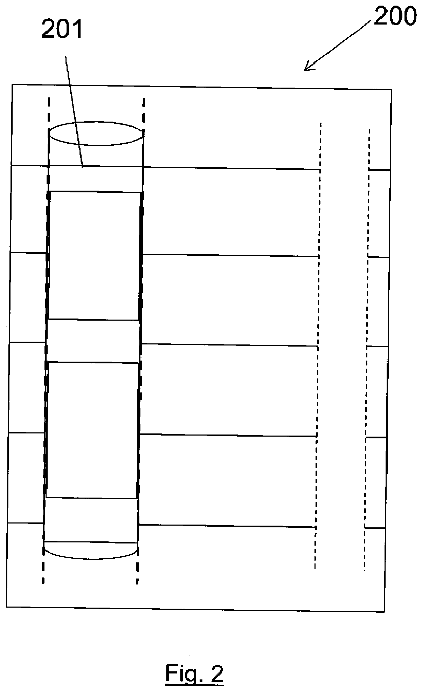

Figure 2 is a schematic view of an equipment enclosure 200 for housing components of an electronic device, the equipment enclosure comprising a cooling device 201. In this embodiment of the invention, the cooling device 201 is the cooling device of Figure 1, however, in other embodiments of the invention the cooling device may be a cooling device including any of the features set out above.

Where in the foregoing description, integers or elements are mentioned which have known, obvious or foreseeable equivalents, then such equivalents are herein incorporated as if individually set forth. Reference should be made to the claims for determining the true scope of the present invention, which should be construed so as to encompass any such equivalents. It will also be appreciated by the reader that integers or features of the invention that are described as preferable, advantageous, convenient or the like are optional and do not limit the scope of the independent claims. Moreover, it is to be understood that such optional integers or features, whilst of possible benefit in some embodiments of the invention, may not be desirable, and may therefore be absent, in other embodiments.

## Claims

1. A cooling device for transferring heat away from components of an electronic device, the cooling device comprising:
a pressure vessel, wherein the pressure vessel comprises an evaporator, and wherein the evaporator arranged to be sufficiently close to a component to enable thermal transfer from a component to the evaporator;
a condenser end; and
a working fluid provided within the pressure vessel,
wherein the working fluid absorbs heat at the evaporator, thereby generating a pressure gradient within the pressure vessel, and wherein the pressure gradient causes the working fluid to away flow from the evaporator end towards the condenser end, thereby transferring heat away from the component.

2. The cooling device of claim 1, further comprising a wick structure, wherein the wick structure is arranged on the inside of the pressure vessel.

3. The cooling device of claim 2, wherein the wick structure is a porous wick structure.

4. The cooling device of claim 2 or claim 3, wherein the wick structure comprises sintered copper powder.

5. The cooling device of claim 2, 3 or 4, wherein the wick structure comprises a plurality of grooves that provide channels running along the longitudinal direction of the pressure vessel.

6. The cooling device of any preceding claim, wherein the condenser end is sufficiently close to a heat exchanger enable thermal transfer from the component to the heat exchanger.

7. The cooling device of any preceding claim, wherein the working fluid is returned to the evaporator from the condenser end and re-used.

8. The cooling device of claim 7, wherein the working fluid is returned to the evaporator under gravity.

9. The cooling device of claim 7, wherein the working fluid is returned to the evaporator via capillary forces developed in the wick structure.

10. The cooling device of any preceding claim, wherein the wording fluid comprises liquid helium, liquid ammonia or alcohol.

11. The cooling device of any preceding claim, wherein the condenser end is bifurcated such that the condenser end comprises at least two branches.

12. The cooling device of claim 11, wherein a heat exchanger is arranged to be sufficiently close to each branch of the condenser end to enable thermal transfer from the condenser end to the heat exchanger.

13. The cooling device of any preceding claim, wherein the evaporator is bifurcated such that the evaporator comprises at least two branches, and wherein each branch is arranged to be sufficiently close to a component to enable thermal transfer from the component to the evaporator branch.

14. A method of cooling components of an electronic device, the method comprising:
providing a pressure vessel, the pressure vessel having an evaporator and a condenser end, and configuring the pressure vessel such that the evaporator is sufficiently close to a component to enable thermal transfer from the component to the evaporator;
providing a working fluid within the pressure vessel; wherein the working fluid absorbs heat from the component at the evaporator, thereby generating a pressure gradient within the pressure vessel,
and wherein the pressure gradient causes the working fluid to away flow from the evaporator towards the condenser end, thereby transferring heat away from the component.

15. An equipment enclosure for housing components of an electronic device comprising a cooling device according to any of claims 1 to 13.
